# DEMANDE DE BREVET EUROPEEN

(11) **EP 3 309 830 A1**
(43) Date de publication de la demande: **18.04.2018**
(21) Numéro de dépôt: 17168077.0
(22) Date de dépôt: 25.04.2017
(51) Int. Cl.: H01L 23/58

(54) **PUCE DE CIRCUIT INTÉGRÉ RENFORCÉE CONTRE DES ATTAQUES FACE AVANT**

(30) Priorité: 11.10.2016 FR 1659803
(71) Demandeur: STMicroelectronics (Crolles 2) SAS, 38920 Crolles (FR); STMICROELECTRONICS (ROUSSET) SAS, 13790 Rousset (FR)
(72) Inventeur: PETITDIDIER, Sébastien, 38660 LA TERRASSE (FR); LISART, Mathieu, 13100 AIX EN PROVENCE (FR)
(74) Mandataire: Thibon, Laurent

(57) **Abrégé**

L'invention concerne une puce de circuit intégré comportant un empilement d'interconnexions, dans lequel est formée une cavité (12), remplie d'au moins un premier matériau (14) ayant une sélectivité au polissage et/ou à la gravure différente de plus de 10 % par rapport aux matériaux (2, 6, 8) formant l'empilement d'interconnexion.

## Description

### Domaine

La présente demande concerne les puces électroniques, plus particulièrement des puces électroniques renforcées contre des attaques effectuées depuis la face avant.

### Exposé de l'art antérieur

Il est fréquent, pour des entreprises ou des pirates, de chercher à analyser le fonctionnement et la composition d'une puce de circuit intégré.

Le pelage des couches successives d'interconnexion d'une puce, et leur analyse, est une technique d'ingénierie inverse permettant d'obtenir des informations sur le fonctionnement de la puce. Cette technique consiste à observer des métallisations, par exemple en cuivre, qui forment les différentes connexions.

Lors de l'analyse d'une puce, les éléments situés sur la puce sont retirés jusqu'à atteindre une première couche d'interconnexion, qui est observée. Les métallisations formant cette couche, et un ou plusieurs isolants entourant les métallisations, sont retirés par gravure ou polissage, selon le matériau. La couche suivante d'interconnexion est ainsi découverte et peut être observée. Cette couche est ensuite retirée à son tour.

Ces opérations sont effectuées sur une seule puce, et non sur une plaque entière de puces. La problématique clé de ces opérations est la capacité à retirer avec précision les couches une à une et à les aplanir correctement. En effet, si certaines régions sont plus (ou moins) découvertes que les régions voisines, l'analyse en sera perturbée. Par exemple, cette différence perturbera la suite du procédé en entrainant la gravure de matériaux appartenant à un niveau d'interconnexion différent de celui traité à un instant donné, et donc la destruction éventuelle de connexions non encore analysées.

### Résumé

On propose ici une structure de puce visant à rendre difficile, voire impossible, la mise en oeuvre de techniques d'ingénierie inverse telles que décrites ci-dessus.

Ainsi, un mode de réalisation prévoit une puce de circuit intégré comportant un empilement de niveaux d'interconnexions, chaque niveau d'interconnexion étant formé d'une couche d'isolant dans laquelle est formée au moins une métallisation, empilement dans lequel est formée une cavité, remplie d'au moins un premier matériau ayant une vitesse de polissage et/ou de gravure différente d'au moins 10 % par rapport au matériau formant les couches dudit isolant.

Selon un mode de réalisation, plusieurs cavités sont formées dans la puce de circuit intégré.

Selon un mode de réalisation, la cavité est formée à travers l'ensemble de l'empilement d'interconnexion.

Selon un mode de réalisation, une partie supérieure de la cavité n'est pas remplie dudit au moins un premier matériau.

Selon un mode de réalisation, ladite partie supérieure contient au moins une métallisation.

Selon un mode de réalisation, la section de la cavité est comprise entre 0,2 et 1 µm.

Un mode de réalisation prévoit un procédé de fabrication comprenant :
former une cavité dans un empilement de niveaux d'interconnexion d'une puce, chaque niveau d'interconnexion étant formé d'une couche d'isolant dans laquelle est formée au moins une métallisation ; et
remplir au moins partiellement la cavité d'au moins un premier matériau dont la vitesse de polissage et/ou de gravure est différente d'au moins 10 % par rapport au matériau formant les couches dudit isolant.

Selon un mode de réalisation, le procédé comprend la formation simultanée de plusieurs cavités.

Selon un mode de réalisation, le procédé comprend la formation d'au moins un niveau d'interconnexion au-dessus de la cavité.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe d'un mode de réalisation d'une puce renforcée ;
les figures 2 à 4 sont des vues en coupe illustrant des étapes de fabrication du mode de réalisation de la figure 1 ; et
la figure 5 est une vue en coupe illustrant une variante de réalisation.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés.

Dans la description qui suit, lorsque l'on fait référence à des qualificatifs de position, tels que les termes "avant", "haut", "dessus", "dessous", "supérieur", "inférieur", etc., il est fait référence à l'orientation des figures.

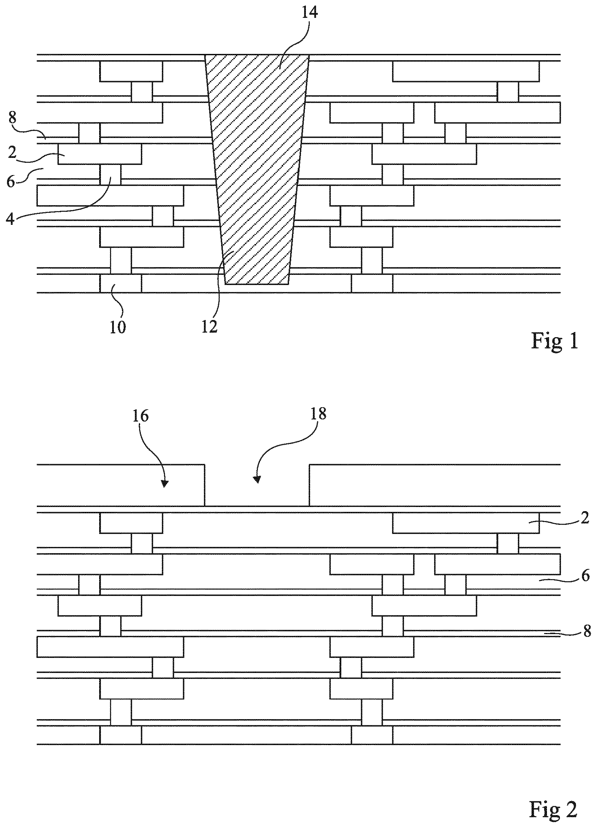

La figure 1 illustre un mode de réalisation d'une puce de circuit intégré à cinq niveaux d'interconnexion. La puce est renforcée contre des attaques face avant. Chaque niveau d'interconnexion comprend des métallisations 2. Chaque métallisation 2 est connectée à la métallisation du niveau d'interconnexion inférieur par un via 4. Dans le mode de réalisation illustré en figure 1, les métallisations 2 d'un même niveau d'interconnexion sont formées dans une même couche d'isolant 6. Une autre couche d'isolant 8, d'arrêt de gravure, est formée au-dessus de chaque niveau d'interconnexion. Les vias 4 du niveau d'interconnexion le plus éloigné de la surface sont connectés à des zones de contact 10 des composants formés dans la puce. L'isolant 6 est par exemple un matériau diélectrique à faible permittivité électrique, comme par exemple du SiOC poreux et l'isolant 8 est par exemple du SiN ou du SiCN. Les métallisations 2 et les vias 4 sont par exemple en cuivre.

Une cavité 12 est formée dans les couches d'isolants 6 et 8 de ces cinq niveaux d'interconnexion. La cavité 12 est remplie d'un matériau 14 ayant une vitesse de polissage et/ou de gravure différente d'au moins 10 % par rapport au matériau formant les couches d'isolant 6 des niveaux d'interconnexion. Le matériau 14 peut être par exemple du nitrure de silicium ou de l'oxyde de silicium dense, par exemple formé par dépôt chimique en phase vapeur (procédé de dépôt dit CVD) à partir d'orthosilicate de tétraéthyle (TEOS).

A titre de variante, les parois de la cavité 12 peuvent être recouvertes d'une couche d'un matériau de gainage, la cavité 12 étant remplie d'un matériau de remplissage. Le matériau de gainage peut être par exemple du nitrure de silicium ou de l'oxyde de silicium (TEOS). Une couche de tantale et/ou de nitrure de tantale, ou de titane et/ou nitrure de titane, peut éventuellement être ajoutée à la couche de gainage. Le matériau de remplissage peut être par exemple du tungstène ou de l'aluminium.

En cas de tentative d'attaque de la face avant de la puce par retrait successif des couches formant les niveaux d'interconnexion, le retrait des couches d'isolant 6, par polissage ou par gravure, soit laisse subsister une portion en relief de matériau de remplissage 14 des cavités 12, soit fait apparaitre une dépression dans le matériau de remplissage 14 des cavités 12. La présence de relief ou de dépression perturbe les étapes ultérieures de retrait des couches formant les niveaux d'interconnexion.

Des cavités 12 peuvent être formées à plusieurs emplacements sur chaque puce. Ces emplacements sont de préférence choisis de manière irrégulière, rendant leurs positions difficiles à prévoir.

Les dimensions des différentes cavités 12 d'une même puce peuvent être variables. Les dimensions de la section, en vue de dessus, sont de préférence comprises entre 0,2 et 1 µm. La forme de la cavité 12 peut aussi être variable. En particulier, la section de la cavité 12 peut être, par exemple, de forme ronde, ovale, carrée ou de toute autre forme réalisable avec les technologies existantes. La structure est éventuellement revêtue d'écrans d'aluminium rendant plus difficile son analyse. Ce dispositif peut être particulièrement utile dans le cas de mémoires ROM contenant des données secrètes mais n'est pas restreint à ce type d'application.

Les figures 2 à 4 illustrent les étapes successives de fabrication de la structure décrite en relation avec la figure 1.

A l'étape de la figure 2, on a formé les différents niveaux d'interconnexion sur la puce. Les emplacements où seront formées les cavités 12 ont été choisis au préalable et aucune métallisation 2 n'y est formée. Seules des couches d'isolants 6 et 8 y sont formées. Un masque 16 est formé sur la surface de la puce et comprend des ouvertures 18 aux emplacements où on veut former des cavités 12.

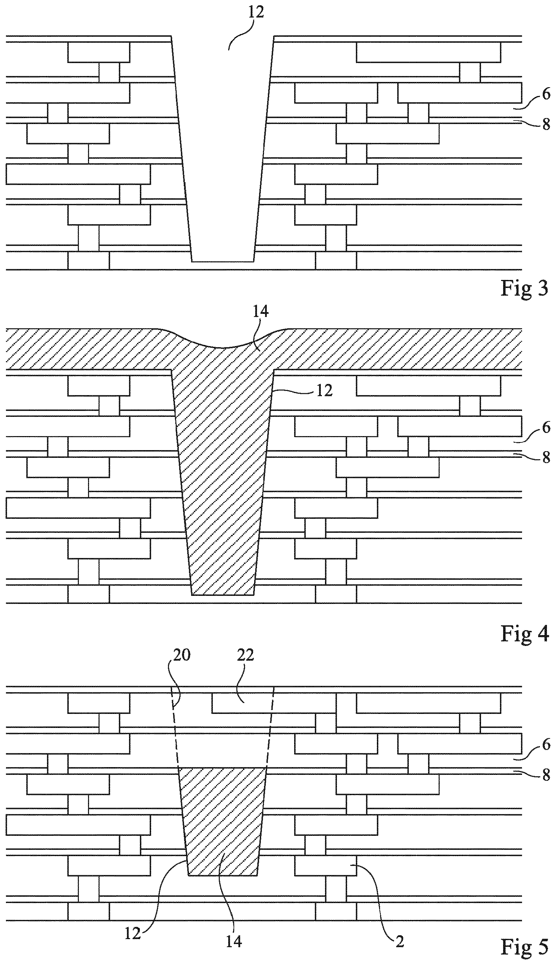

A l'étape illustrée en figure 3, une cavité 12 est formée dans les couches d'isolants 6 et 8 à travers l'ouverture 18 laissée dans le masque 16. La cavité 12 est formée par des gravures anisotropes sélectives successives des couches isolantes 6 et 8 successives. Ces gravures sont par exemple des gravures plasma. Le masque 16 est ensuite retiré de la surface de la puce.

A l'étape illustrée en figure 4, on dépose uniformément une couche d'un matériau 14, par exemple par pulvérisation. L'épaisseur de la couche de matériau 14 est suffisante pour remplir la cavité 12. La puce est ensuite polie, par exemple par polissage mécano-chimique (CMP), de manière à retirer le matériau 14 situé hors de la cavité 12.

A titre de variante, comme cela a été décrit en relation avec la figure 1, le matériau 14 remplissant la cavité 12 peut comprendre un ou plusieurs matériaux de gainage et un matériau de remplissage. De la même manière que pour la couche de matériau 14, l'épaisseur totale des couches de matériaux de gainage et de remplissage est suffisante pour remplir la cavité 12. Les matériaux situés hors de la cavité 12 sont retirés, par exemple par polissage mécano-chimique.

Le matériau 14, de même que les matériaux de remplissage mentionnés précédemment, ont une vitesse de polissage et/ou de gravure différente d'au moins 10 % par rapport au matériau formant les couches d'isolant 6 des niveaux d'interconnexion. Ainsi, lors d'une tentative de polissage d'un niveau d'interconnexion de la puce, le matériau 14 de la cavité 12 sera retiré plus ou moins vite que les matériaux voisins et formera une dépression ou un relief sur la surface de la puce. Ce manque de planéité pourra rendre difficile l'analyse des métallisations successives et pourra par exemple entrainer, dans le cas d'une dépression, la gravure d'un niveau d'interconnexion inférieur au niveau d'interconnexion analysé à un instant donné.

La figure 5 illustre un autre mode de réalisation. La cavité 12 de cette structure ne s'étend que sur une partie de la hauteur des niveaux d'interconnexion. La cavité 12 n'a pas été creusée jusqu'au niveau d'interconnexion le plus éloigné de la surface. Une partie supérieure 20, située au-dessus de la cavité 12 et encadrée de pointillés en figure 5, peut être remplie d'un ou plusieurs autres matériaux. Dans la structure de la figure 5, des couches d'isolants 6 et 8 ainsi qu'une métallisation 22 ont été formées dans la partie supérieure 20.

A titre de variante, la cavité 12 peut être creusée à travers l'ensemble des couches isolantes 6 et 8, et n'être remplie que partiellement de matériau 14 avant d'être recouverte d'autres matériaux. La cavité 12 peut aussi être creusée seulement à travers quelques couches d'isolants 6 et 8, par exemple trois couches d'isolant 6 et deux couches d'isolant 8, et être entièrement remplie de matériau 14. Dans ce cas, il est possible d'avoir des métallisations 2 dans les niveaux d'interconnexion sous la cavité.

Un avantage de ces modes de réalisation est qu'ils utilisent des technologies usuelles, généralement utilisées dans le procédé de fabrication d'une puce de circuit intégré.

Des modes de réalisation particuliers ont été décrits. Diverses variantes et modifications apparaîtront à l'homme de l'art. En particulier, les divers matériaux peuvent être remplacés par des matériaux équivalents.

## Revendications

1. Puce de circuit intégré comportant un empilement de niveaux d'interconnexions, chaque niveau d'interconnexion étant formé d'une couche d'isolant (6) dans laquelle est formée au moins une métallisation (2), empilement dans lequel est formée une cavité (12), remplie d'au moins un premier matériau (14) ayant une vitesse de polissage et/ou de gravure différente d'au moins 10 % par rapport au matériau formant les couches dudit isolant (6).

2. Puce de circuit intégré selon la revendication 1, dans laquelle sont formées plusieurs cavités (12).

3. Puce de circuit intégré selon la revendication 1 ou 2, dans laquelle la cavité (12) est formée à travers l'ensemble de l'empilement d'interconnexion.

4. Puce de circuit intégré selon la revendication 1 ou 2, dans laquelle une partie supérieure (20) de la cavité (12) n'est pas remplie dudit au moins un premier matériau (14).

5. Puce de circuit intégré selon la revendication 4, dans laquelle ladite partie supérieure (20) contient au moins une métallisation (2).

6. Puce de circuit intégré selon l'une quelconque des revendications 1 à 5, dans laquelle la section de la cavité (12) est comprise entre 0,2 et 1 µm.

7. Procédé de fabrication comprenant :
former une cavité (12) dans un empilement de niveaux d'interconnexion d'une puce, chaque niveau d'interconnexion étant formé d'une couche d'isolant (6) dans laquelle est formée au moins une métallisation (2) ; et
remplir au moins partiellement la cavité (12) d'au moins un premier matériau (14) dont la vitesse de polissage et/ou de gravure est différente d'au moins 10 % par rapport au matériau formant les couches dudit isolant (6).

8. Procédé de fabrication selon la revendication 7, comprenant la formation simultanée de plusieurs cavités (12).

9. Procédé de fabrication selon la revendication 7 ou 8, comprenant la formation d'au moins un niveau d'interconnexion au-dessus de la cavité (12).
